Europäisches Patentamt

European Patent Office

Office européen des brevets

(19)

(11) Veröffentlichungsnummer: **0 173 641**
A2

## (12) EUROPÄISCHE PATENTANMELDUNG

(21) Anmeldenummer: 85730101.4

(22) Anmeldetag: 25.07.85

(51) Int. Cl.⁴: **C 30 B 9/00**, C 30 B 11/00, C 30 B 29/46

(30) Priorität: 27.07.84 DE 3428262

(43) Veröffentlichungstag der Anmeldung: 05.03.86
Patentblatt 86/10

(84) Benannte Vertragsstaaten: AT BE CH DE FR GB IT LI LU NL SE

(71) Anmelder: Hahn-Meitner-Institut für Kernforschung Berlin GmbH, Glienicker Strasse 100, D-1000 Berlin 39 (DE)

(72) Erfinder: Tributsch, Helmut, Prof. Dr. rer. nat., Alsenstrasse 24, D-1000 Berlin 39 (DE)
Erfinder: Lewerenz, Hans-Joachim, Dr. rer. nat., Am Kleinen Wannsee 12K, D-1000 Berlin 39 (DE)
Erfinder: Spiesser, Michel, Dr., 14, Avenue de l'Eperonnière, F-44000 Nantes (FR)

(74) Vertreter: Wolff, Konrad, Heinrich-Hertz-Institut für Nachrichtentechnik Berlin GmbH Einsteinufer 37, D-1000 Berlin 10 (DE)

(54) Halbleiterschicht auf einem Übergangsmetalldichalcogenid, Verfahren zu deren Herstellung und Verwendung derartiger Halbleiterschichten für Solarzellen.

(57) Halbleiterschichten aus Übergangsmetalldichalcogeniden, insbesondere der Zusammensetzung MX₂ (M = W, Mo; X = S, Se, Te), in einem besonders angepassten Verfahren hergestellt, ermöglichen deren Verwendung in Solarzellen. Es werden grossflächige Schichten aus zweidimensionalen Kristallen 4 mit gutem photoelektrischen Verhalten zur Verfügung gestellt. Die Halbleiterschicht wird an der Grenzschicht 5 einer innerhalb eines Kristallisationsgefässes 1 befindlichen Schmelze 2 und der darüber befindlichen Gasphase 3 des Schmelzematerials erzeugt. Die zweidimensional, mit grossen Oberflächen 8 und kleinen seitlichen Stufen 9 zur Halbleiterschicht anwachsenden Kristalle 4 der Zusammensetzung MX₂ sind als photovoltaische und photoelektrische grossflächige halbleitende Schichten für Solarzellen geeignet.

0173641

HAHN-MEITNER-INSTITUT FÜR KERNFORSCHUNG BERLIN GMBH

61/0784 EP

Halbleiterschicht aus einem Übergangsmetalldichalcogenid, Verfahren zu deren Herstellung und Verwendung derartiger Halbleiterschichten für Solarzellen

Die Erfindung bezieht sich auf Halbleiterschichten aus Übergangsmetalldichalcogeniden, besonders zu deren Herstellung angepaßte Verfahren und auf die Verwendung derartiger Halbleiterschichten für Solarzellen.

Aufgrund ihrer optischen und elektronischen Eigenschaften kommen geschichtete Übergangsmetalldichalcogenide der Gruppe VI für die wirksame Solarenergie-Umwandlung als erfolgversprechende Materialien ernsthaft in Betracht. Mit indirekten Übergängen bei geringer Energie, welche von direkten Übergängen mit hohem Absorptionsvermögen ($\alpha \sim 10^5$ cm$^{-1}$) bei Photonen-Energien von etwa 1,5 eV (WSe$_2$, MoSe$_2$) gefolgt werden, und Minoritätsträger-Diffusionslängen von etwa 2 µm kann es möglich sein, Solarenergie mittels Dünnfilmstrukturen wirksam in elektrische Energie umzuwandeln.

Untersuchungen an photoelektrochemischen Solarzellen haben gezeigt, daß, obwohl mit diesen Halbleitern eine außergewöhnliche Stabilität gegen Photokorrosion erzielt wurde, in Abhängigkeit von den Proben große Variationen im Photostrom ($i_{sc}$), in der Photospannung ($V_{oc}$) und im Füllfaktor auftreten. Diese Unterschiede lassen sich wohl auf Variationen in der Oberflächenmorphologie und auf Abweichungen in der Stöchiometrie zurückführen. Insbesondere wurde festgestellt, daß Stufen in den Oberflächen des Schichtgittermaterials für die Solarzellenausbeute nachteilig sind. Dies gilt auch für Dotierungsschwankungen innerhalb eines Kristalles.

Eine umfangreiche Materialauslese hat zur Entwicklung einer photoelektrochemischen Solarzelle mit n-$WSe_2$ geführt, welche Solarenergie in elektrische Energie mit einem Wirkungsgrad von 10 % umwandelt. Durch chemischen Transport (CVT) aus diesem Material hergestellte Kristalle müssen jedoch bezüglich ihres Oberflächengefüges und ihrer Dotierungsprofile besonders ausgewählt werden, da dieser Prozeß die Reproduzierbarkeit und die Gleichförmigkeit der Kristalle nicht gewährleistet. Hinzukommt, daß nur relativ kleine Kristallite von maximal 50 $mm^2$ mittels chemischem Transport (CVT) erhalten werden.

Es sind beachtliche Anstrengungen unternommen worden, um zweidimensional wachsende $MX_2$-Materialien (M = Mo, W; X = S, Se, Te) als großflächige, gleichförmig photoaktive Schichten darzustellen. Alle bisher untersuchten Methoden führten zu hohen Konzentrationen von Stufen mit Defekten, welche die Energieausbeute durch Rekombinationsprozesse extrem reduzieren.

Bekannt ist bereits die Verwendung von Tellur als Schmelze zur Züchtung von Kristallen, welche Elemente der Gruppen II bis IV enthalten. Auch sind damit bereits Kristalle von Übergangsdichalcogeniden hergestellt worden. Offenbar ist es bisher jedoch nicht gelungen, dabei dünne großflächige polykristalline Filme von $MX_2$-Materialien aus einer solchen Schmelze zu erzielen.

Da die Lichtabsorption von einigen Übergangsmetalldichalcogeniden in dem für die Sonnenenergieumwandlung interessanten Wellenlängenbereich sehr hoch ist, können diese Vorzüge dann voll zur Geltung kommen, wenn es gelingt, dünne glatte Schichten zur Verfügung zu haben, mit denen sich effizient Sonnenenergie in elektrische Energie umwandeln läßt.

Der Erfindung liegt daher die Aufgabe zugrunde, derartige großflächige Schichten aus zweidimensional kristallisiertem Übergangsmetalldichalcogenidmaterial mit gutem photoelektrischen Verhalten zu schaffen.

Die Halbleiterschichten, mit denen diese Aufgabe gemäß der Erfindung gelöst wird, sind durch die im Patentanspruch 1 aufgeführten Merkmale gekennzeichnet.

Als besonders geeignet haben sich dabei Übergangsmetalldichalcogenide der Zusammensetzung $MX_2$ oder $M_{1-x}M_xX_2$ mit M = Wolfram (W) und/oder Molybdän (Mo) und X = Schwefel (S), Se (Selen) oder Tellur (Te) erwiesen.

Von wesentlicher Bedeutung für die Erfindung ist die Herstellung derartiger Erzeugnisse. Die Veränderungen, die das Material zu erfahren hat, um hernach die gewünschten Eigenschaften aufzuweisen, sind nur durch besonders angepaßte Verfahrensschritte erreichbar. Der Patentanspruch 3 enthält die erfindungsgemäße, umfassende technische Lehre hierzu.

Dieses Verfahren sieht somit die Orientierung zweidimensional wachsender, schichtgitterartiger Kristalle der Zusammensetzung $MX_2$ bzw. $M_{1-x}M_xX_2$ mit M = W, Mo bzw. $M_{1-x}$ = W; $M_x$ = Mo und X = S, Se, Te mit dem Ziel

0173641

vor, großflächige halbleitende Schichten zu erzeugen, die sich für die Umwandlung von Sonnenenergie in elektrische Energie eignen. Die Kristallzucht der Halbleiterschicht erfolgt dabei an der Oberfläche der Schmelze bzw. an der Grenzfläche zwischen der Schmelze und der Gasphase des Schmelzematerials, wobei sich die Kristalle, deren spezifisches Gewicht höher ist als das der Schmelze, entgegen der Schwerkraft nach oben bewegen.

Es kann vorteilhaft eine Schmelze benutzt werden, die insbesondere aus flüssigem Tellur (Te) besteht. Dieses Schmelzematerial bleibt in weitem Temperaturbereich flüssig und besitzt einen niedrigen Dampfdruck. Es hat auch die Eigenschaft, die Verbindung insbesondere der Zusammensetzung $MX_2$ gut zu lösen.

Ebenfalls gut als Schmelzematerial geeignet ist Selen (Se), außerdem auch Gemische aus Selen und Tellur sowie Bleichlorid ($PbCl_2$) und Wismut (Bi).

Zur Kristallzucht wird ein Gefäß benötigt, welches eine der gewünschten Schichtgröße entsprechende Grenzfläche von Schmelze und Gasraum gewährleistet. Das Gefäß kann insbesondere aus Quarz bestehen. Weitere mögliche Materialien für das Kristallzuchtgefäß sind Aluminiumoxid oder Silizium-Aluminiumlegierungen.

Detailliertere Angaben zu den einzelnen Schritten eines bevorzugten Ausführungsbeispiels des erfindungsgemäßen Verfahrens sind im Patentanspruch 7 aufgeführt. Das Halbleitermaterial der Zusammensetzung $MX_2$, das als polykristalline Schicht mit guter Ausrichtung und

0173641

einem kleinen Anteil von Stufen, d.h. geringst möglichem Anteil von Kantenoberflächen, welche senkrecht zur Schichtoberfläche liegen, kristallisieren soll, wird der Schmelze zugesetzt, wobei die Menge entsprechend dem Volumen der gewünschten Schicht berechnet wird. Die Homogenisierung kann mechanisch oder durch Ultraschall erfolgen. Bei Verringerung der Löslichkeit infolge Temperaturerniedrigung kristallisiert das Halbleitermaterial aus,und die Halbleiterschicht wächst auf der Oberfläche der Schmelze.

Die Kristallisation an der Grenzfläche zwischen Oberfläche der Schmelze und Gasphase der Schmelze kann durch eine Platte beeinflußt und verbessert werden, die sich an der Grenzfläche befindet, d.h. entweder dicht über der Schmelze gehalten wird oder sogar die Oberfläche der Schmelze gleitend berührt. Hierdurch wird ein Temperaturgradient für die Kristallisationskeime erzielt. Im Falle der gleitenden Berührung kann die Platte mit unter Druck aufgewalzten Mikrokristallen der zu züchtenden Verbindungen beschichtet sein, wodurch die Kristallisation zur unteren Plattenfläche verbessert wird.

Die Trennung der gezüchteten Halbleiter-Kristallschicht von der Schmelze kann entweder durch einen Temperaturgradienten herbeigeführt werden, wodurch die Schmelze an einer kälteren Stelle des Kristallisationsgefäßes kondensiert, oder z.B. auch durch Anlegen eines Vakuums, wobei sich die Schmelze im Bedarfsfall durch eine gesinterte Schicht aus Quarzglas abfiltern läßt. Weiterhin ist auch ein seitliches Ablassen der Schmelze und nachfolgende Sublimierung der Schmelze oder dgl. möglich.

Die erfindungsgemäße Verwendung derartiger Halbleiterschichten liegt bei Solarzellen. Dabei kann es sich sowohl um photovoltaische als auch um photoelektrische Solarzellen handeln.

Die wesentliche Bedeutung der Erfindung liegt in der größtmöglichen Ausrichtung der Kristallflächen zum Schichtwachstum parallel zur Van-der-Waals-Oberfläche. Dabei werden Kristallschichten mit glatter, stufenarmer Oberfläche erzeugt. Durch die Vermeidung von Stufen auf den Schichtgitterkristallfilmen wird deren Wirkung als Rekombinationszentren vermieden, so daß eine Rekombination von Ladungsträgern und Verluste bei der Energieumwandlung nicht mehr oder nur noch in unwesentlichem Maße auftreten, wodurch der Photostrom, die Photospannung und der Füllfaktor einer mit diesem Material betriebenen Solarzelle erhöht werden können.

Weitere Einzelheiten der Erfindung werden nachfolgend im Zusammenhang mit der Beschreibung der bildlichen Darstellungen näher erläutert. Dabei zeigen:

Fig. 1: eine Darstellung zur Erläuterung des Kristallwachstums einer Halbleiterschicht an der Grenzfläche zwischen einer Schmelze und einer Schmelzematerial-Gasphase;

Fig. 2: Darstellungen mehrerer Methoden zum Eliminieren der Schmelze durch a) Filtrierung, b) Destillation und c) Ableitung mit nachfolgender Sublimierung;

Fig. 3: rasterelektronenmikroskopische Aufnahmen einer $MoSe_2$-Schicht, welche an der Oberfläche einer Tellurschmelze hergestellt wurde;

Fig. 4: ein Schaubild für das photoelektrochemische Verhalten von n-MoSe$_2$, welches aus einer Tellurschmelze gewonnen wurde;

Fig. 5: die Leistungscharakteristik einer MoSe$_2$-Schicht in einer regenerativen elektrochemischen Solarzelle mit $J^-/J_2$ als Redoxsystem unter AM1-Belichtung;

Fig. 6: die Photostrom-Spannungscharakteristik einer mit Silber behandelten n-MoSe$_2$-Elektrode, welche in Gegenwart von $J^-/J_2$ aus einer Tellurschmelze gezogen wurde

und Fig. 7 und 8: Darstellungen zur Erläuterung der Ansammlung von Kristallen an der Oberfläche der Schmelze zur Erzielung des seitlich einsetzenden Wachstums einer Halbleiterschicht, in Fig. 8 an der Unterseite einer Platte.

Zunächst soll aber noch auf die Herstellung von Halbleiterschichten aus Übergangsmetalldichalcogeniden, insbesondere der Zusammensetzung MX$_2$ (M = W, Mo; X = S, Se, Te) bzw. der Zusammensetzung M$_{1-x}$M$_x$X$_2$ (M$_{1-x}$ = W, M$_x$ = Mo) anhand eines Ausführungsbeispieles genauer eingegangen werden, bei welchem Tellur (Te) als Schmelze 2 und Gasphase 3 verwendet wird.

Bei diesem Ausführungsbeispiel im Labormaßstab wurde pulverförmiges Übergangsmetalldiselenid zweifach destilliertem Tellur (Te) in einem Verhältnis von 1 : 100 zugefügt. Auf je 10 g dieses Gemisches wurden außerdem 100 mg Selen (Se) für eine bessere Kontrolle der gewünschten Reaktion zugegeben. Das Ausgangsmaterial wurde dann in eine Ampulle aus Quarz von 20 mm Durchmesser eingekapselt und auf eine Temperatur von 1050 $^o$C

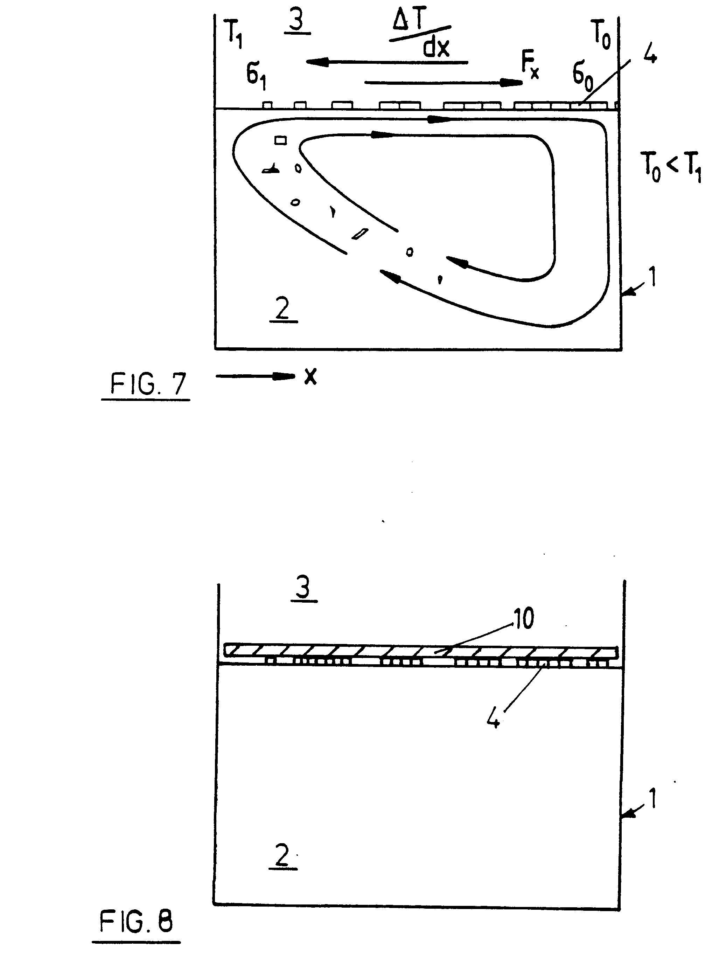

erhitzt. Dabei bildeten sich in der Quarzampulle, welche als Kristallisationsgefäß diente, unten eine Tellur-Schmelze 2 und oberhalb derselben eine Tellur-Gasphase 3 aus. Anschließend wurde das Material mit einem Temperaturgradienten von einigen 1/100-Grad pro Stunde gekühlt. Während des Kühlprozesses begannen sich Übergangsmetalldichalcogenid-Kristalle 4 sowohl in der flüssigen Schmelze 2 als auch in der Schmelze/Dampf-Zwischenschicht abzuscheiden. Es trat eine Wirkung auf, welche Konvektion und Oberflächenspannung einschließt und die Kristallisation in der Tellur-Schmelze/Dampf-Zwischenschicht 5 erleichterte, obwohl die Dichte des Halbleitermaterials größer ist als die Dichte der Schmelze 2. Der Mechanismus, als Marangoni-Effekt gedeutet, ist in Fig. 7 schematisch dargestellt.

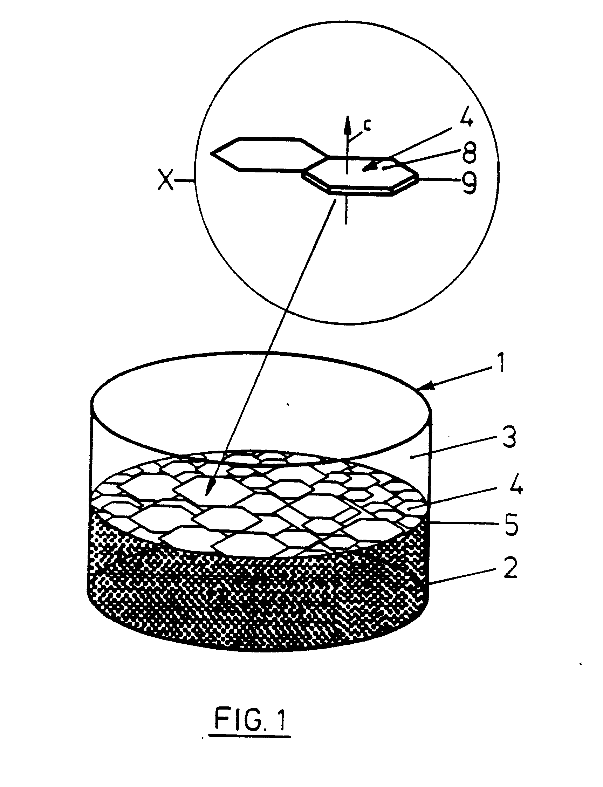

In Fig. 1 ist ein Kristallzuchtgefäß 1 dargestellt, das eine der gewünschten Halbleiterschichtgröße entsprechende Grenzfläche von Schmelze 2 und Gasphasenraum 3 gewährleisten muß. Das Kristallisationsgefäß 1 kann insbesondere aus Quarz bestehen. Es können auch Aluminiumoxid, Zirkonoxid oder Silizium-Aluminiumlegierungen als weitere Materialien für das Kristallisationsgefäß 1 verwendet werden.

Das Quantum der der Tellur-Schmelze 2 hinzugefügten Übergangsmetalldichalcogenide ist entsprechend dem Volumen der gewünschten Halbleiterschicht zu berechnen. Eine Homogenisierung des Gemisches aus Schmelze 2 und darin zwischen 600 $^\circ$C und 1000 $^\circ$C gelöstem Halbleitermaterial kann mechanisch oder durch Ultraschall erfolgen. Nach der Beendigung des Wachstumsprozesses kristallisiert bei anschließender Verringerung der Löslichkeit der Schmelze infolge einer Temperaturerniedrigung die Halbleiterschicht auf der Schmelze aus. Gute Resultate werden dann erzielt, wenn als Ausgangstemperatur für die Temperaturerniedrigung 1050 $^{\circ}$C gewählt werden.

Die Kristallisation an der Grenzfläche 5 zwischen Tellur-Schmelze 2 und Tellur-Gasphase 3 kann durch eine Platte 10 beeinflußt und verbessert werden (vgl. Fig. 8), die dicht über die Tellur-Schmelze gehalten wird und im Extremfall die Oberfläche der Schmelze 2 gleitend berührt. Die Platte 10 bewirkt einen Temperaturgradienten zur Bildung von Kristallisationskeimen. Bei gleitender Berührung der Schmelze 2 kann die Platte 10 mit Mikrokristallen der zu züchtenden Verbindungen, die unter Druck aufgewalzt sind, beschichtet sein, wodurch die Kristallisation zur unteren Plattenfläche verbessert wird.

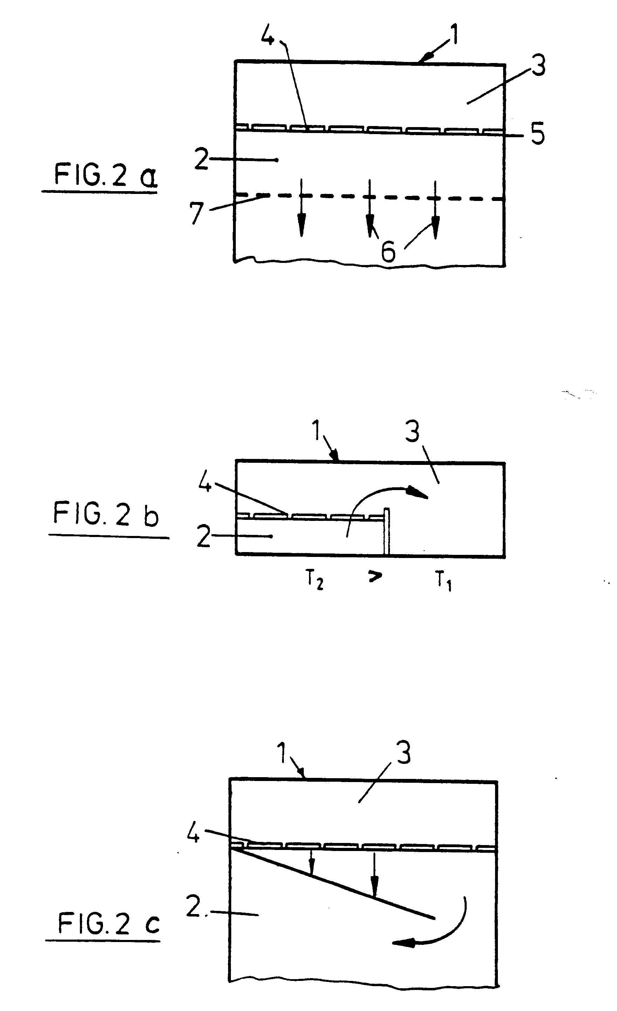

Nach Beendigung des Wachstumsprozesses wird die Kristallschicht 4 von der Schmelze 2 getrennt. Dies kann z.B. gemäß Fig. 2 auf drei verschiedene Arten erfolgen. Gemäß Fig. 2a kann an das Kristallisationsgefäß 1 ein Vakuum angelegt und die Schmelze 2 durch eine gesinterte Schicht 7 in Richtung der Pfeile 6 aus dem Gefäß 1 abgefiltert werden. Gemäß Fig. 2 b kann durch einen Temperaturgradienten die Schmelze 2 an einer kälteren Stelle des Kristallisationsgefäßes 1 kondensiert werden, wobei $T_1 < T_2$ ist. Gemäß Fig. 2 c wird durch seitliches Ablassen der Schmelze 2 und nachfolgende Sublimierung eine Trennung der Kristallschicht 4 von der Schmelze herbeigeführt.

In Versuchen wurden $MoSe_2$, $MoTe_2$ und $WSe_2$ präpariert. Die Kristallit-Abmessungen erreichten 60 mm$^2$ mit einer

Dicke von näherungsweise 0,3 mm. Die hierbei erhaltenen Übergangsmetalldiselenide hatten eine Stöchiometrie $MSe_{2-x}Te_x$ (M = Mo, W) mit X < 0,1. Der Tellurgehalt der Kristalle konnte durch Beheizung der Proben in einer Selen-Atmosphäre auf 650 $^{o}$C noch vermindert werden. Das untersuchte $MoSe_2$-Material zeigte noch feststellbare Mengen von Tellur und einige Übergangsmetallverunreinigungen.

Alle präparierten Halbleiterschichten waren photoaktiv. $MoSe_2$ und $MoTe_2$ hatten n-Typ-Leitfähigkeit, und $WSe_2$ zeigte p-Typ-Leitfähigkeit. Die Halbleiter zeigten Photostrom-Dichten von einigen $mA/cm^2$ bei simulierten AM1-Bedingungen. $MoSe_2$ wurde wegen seines hohen Photopotentiales für die Untersuchung ausgewählt.

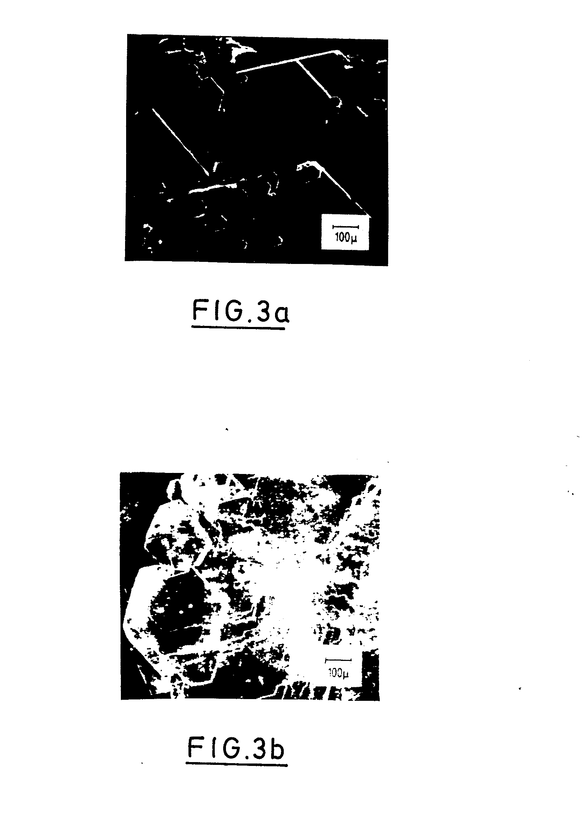

Der morphologische Aufbau einer gewonnenen Halbleiterschicht ist in Fig. 3 in rasterelektronenmikroskopischen Aufnahmen einer $MoSe_2$-Schicht dargestellt, welche auf der Oberfläche einer Tellur-Schmelze 2 hergestellt wurde, wobei die Ausgangstemperatur für die Abkühlung 1050 $^{o}$C betrug. Diese Aufnahmen zeigen, daß die Kristalle 4 parallel zu ihren Schichtoberflächen zusammengewachsen sind und eine feste seitliche Verbindung hexagonaler Kristalliten entlang ihrer Kanten aufweisen. Die Kristalle sind ähnlich Glimmer in großflächigen Blättern bzw. großflächigen Materialschichten zusammengewachsen. Die Kristallite liegen teilweise übereinander, woraus die Bildung von kleinen Stufen resultiert. Das Detail X in Fig. 1 zeigt schematisch die großflächigen Wachstumsoberflächen 8 der Kristalle 4 senkrecht zum Pfeil c und die kleinen seitlichen Stufen 9 parallel zum Pfeil c.

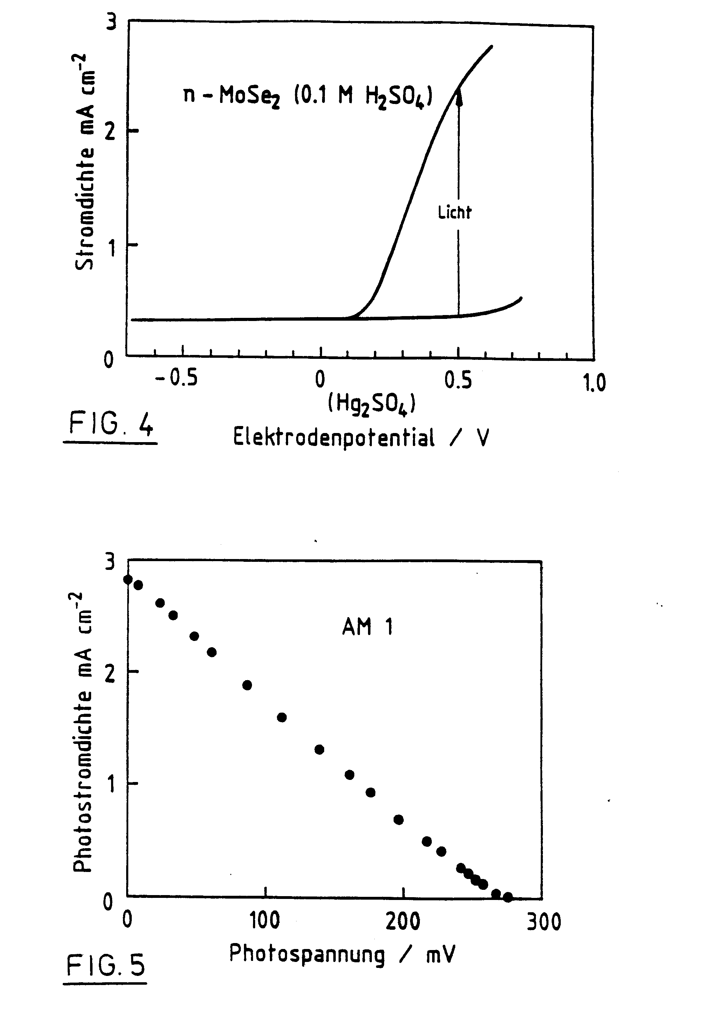

Die photoelektrischen Eigenschaften dieser Halbleiterschichten sind in Fig. 4 dargestellt. Diese zeigt das photoelektrochemische Verhalten von n-MoSe$_2$, welches aus einer Tellurschmelze 2 gewonnen wurde. Die Messung der Photoströme erfolgte ohne Zusatz von Redoxsystemen zum Elektrolyten.

Die Fig. 5 zeigt die Leistungscharakteristik einer MoSe$_2$-Schicht in einer stromerzeugenden, regenerativen elektrochemischen Solarzelle mit $J^-/J_2$ als Redoxsystem. Die Belichtung ist auf AM1-Verhältnisse genormt, welche der solaren Intensität an der Erdoberfläche entsprechen, bei senkrechtem Lichteinfall auf 0 m über Normalnull (NN).

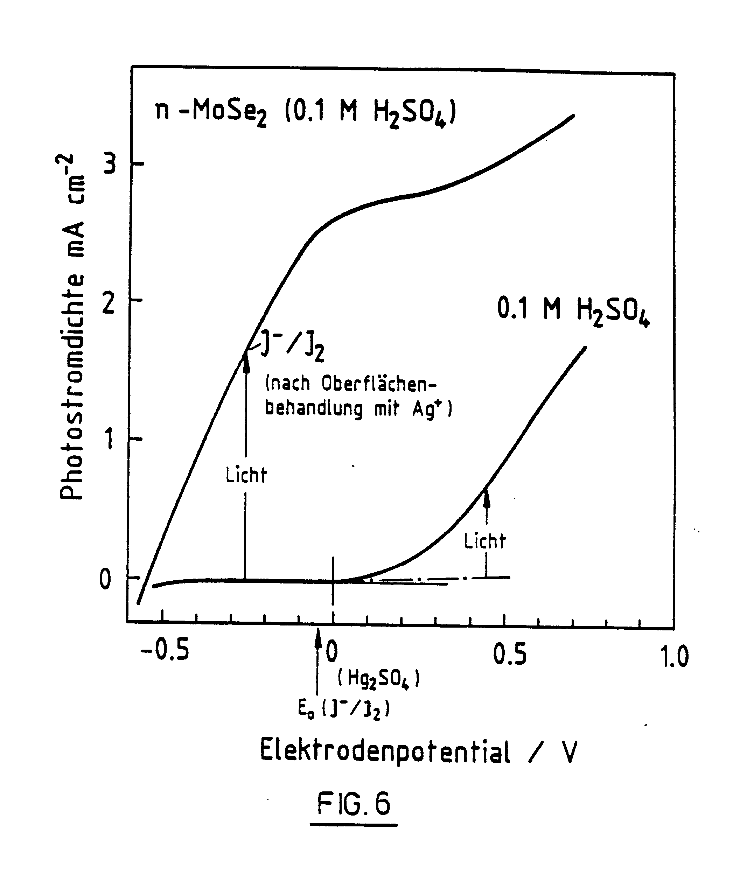

Durch chemische und elektrochemische Behandlung der Schichtoberfläche, welche die schon durch die erfindungsgemäße technische Lehre herabgesetzte Einwirkung auf die Stufenoberflächen weiter verringert, können die photoelektrischen Eigenschaften der Schichtoberfläche weiter verbessert werden. Ein Beispiel der Eigenschaften einer solchen oberflächenbehandelten Schicht zeigt die Fig. 6 als Photostrom-Spannungscharakteristik einer mit Silberionen (Ag$^+$) behandelten n-MoSe$_2$-Elektrode, welche aus einer Tellur-Schmelze 2 gezogen wurde. Hiermit ist nachgewiesen, daß die Herstellung von Halbleiterschichten zweidimensional wachsender MX$_2$-Verbindungen mit brauchbaren photoelektrischen Eigenschaften für die Solar-Energieumwandlung in photoelektrochemischen und photovotaischen Solarzellen führt. Die technische Realisierung von großflächigen, polykristallinen Dünnfilmschichten von z.B. MoSe$_2$ und WSe$_2$ ist für den Aufbau derartiger Solarzellen möglich.

Die Fig. 7 zeigt das Oberflächenwachstum von Kristallen 4 zur Erzielung eines seitlich beginnenden Anwachsens, was auf den Marangoni-Effekt zurückzuführen ist. Die Oberflächenspannung $\sigma$ ist ein kritischer Parameter für die Bildung von Kristallisationskernen und nicht nur von der Konzentration der Schmelze 2 sondern auch von deren Temperatur abhängig. Der Temperaturgradient $\frac{\Delta T}{\Delta x}$ in der Ebene der Oberfläche der Schmelze 2 resultiert in einer Kraft $F_x$ parallel zur Oberfläche, deren Ursprung die Differenz in der Oberflächenspannung $\sigma$ ist. Es ergibt sich eine Konvektion, welche die Kristallisationskerne aus der Masse der Schmelze 2 an die Oberfläche an Stellen der höheren Temperatur $T_1$ des Gefäßes 1 transportiert und einen nachfolgenden Transport der langsam wachsenden Kristalle 4 entlang der Grenzschicht zwischen Schmelze 2 und Gasphase 3 hervorruft. Die größeren Kristallite an den Stellen mit höherer Oberflächenspannung $\sigma$ folgen der Konvektion der Schmelze 2 nicht, da die anwachsende Oberflächenspannung $\sigma$ dem Absinken der Kristalliten entgegenwirkt.

Das in der bereits weiter oben schon erwähnten Fig. 8 dargestellte Kristallisationsgefäß 1 weist oberhalb der Schmelze 2 eine Platte 10 auf, an deren Unterfläche die aus der Schmelze 2 tretenden Kristalle 4 anwachsen. Für die Entstehung eines entsprechenden Temperaturgradienten zwischen Schmelze 2 und Platte 10, welche von der Gasphase 3 der Schmelze 2 umgeben ist, kann beispielsweise durch eine Kühlung und thermische Isolierung der Platte 10 (nicht dargestellt) gesorgt werden.

0173641

HAHN-MEITNER-INSTITUT FÜR KERNFORSCHUNG BERLIN GMBH

61/0784 EP

Patentansprüche

1. Halbleiterschicht aus einem Übergangsmetalldichalcogenid,

g e k e n n z e i c h n e t   durch

- eine Oberflächenstruktur, in der die Kristalle zweidimensional symmetrisch, parallel zur Schichtoberfläche, ausgerichtet sind und in der der Anteil der senkrecht zur Schichtoberfläche liegenden Kristallkantenflächen gering bis vernachlässigbar klein ist,

- eine durchgehende Schichtfläche von mehr als 50 mm$^2$,

- eine Schichtdicke von bis hinab zu ca. 0,1 mm und

- eine homogene Dotierung im Halbleitermaterial.

2. Halbleiterschicht nach Anspruch 1,

g e k e n n z e i c h n e t   durch

ein Übergangsmetalldichalcogenid der Zusammensetzung $MX_2$ oder $M_{1-x}M_xX_2$ mit M = W,Mo bzw. $M_{1-x}$ = W, $M_x$ = Mo und X = S, Se, Te.

3. Verfahren zur Herstellung einer Halbleiterschicht nach Anspruch 1 oder 2,

d a d u r c h   g e k e n n z e i c h n e t ,   daß die Kristallite (4) an der Oberfläche einer in einem Kristallisierungsgefäß (1) befindlichen Schmelze (2) abgeschieden werden und zur Halbleiterschicht zusammenwachsen, wobei die Oberfläche der Schmelze (2) vom Schmelzematerial in gasförmiger Phase (3) bedeckt ist.

4. Verfahren nach Anspruch 3,

d a d u r c h   g e k e n n z e i c h n e t ,   daß die Schmelze (2) aus Tellur (Te), Selen (Se) oder einem Gemisch aus Tellur (Te) und Selen (Se) besteht.

0173641

5. Verfahren nach Anspruch 3,
d a d u r c h   g e k e n n z e i c h n e t ,   daß
die Schmelze (2) aus Bleichlorid ($PbCl_2$) besteht.

6. Verfahren nach Anspruch 3,
d a d u r c h   g e k e n n z e i c h n e t ,   daß
die Schmelze (2) aus Wismut (Bi) besteht.

7. Verfahren nach einem der Ansprüche 3 bis 6,
d a d u r c h   g e k e n n z e i c h n e t ,   daß
- die Schmelze (2) bis auf ca. 1050 $^\circ$C erwärmt wird,
- das Übergangsmetalldichalcogenid in der Menge, die
  dem Volumen der herzustellenden Halbleiterschicht
  entspricht, der Schmelze (2) zugesetzt und in dieser
  gelöst wird,
- eine Homogenisierung der flüssigen Phase aus Schmelze
  (2) und gelöstem Halbleitermaterial zwischen 1000 $^\circ$C
  und 600 $^\circ$C durchgeführt wird,
- die Löslichkeit der Schmelze (2) durch Temperaturerniedrigung herabgesetzt und dadurch das Abscheiden
  der Halbleitermaterialkristalle und deren Zusammenwachsen zur gewünschten Halbleiterschicht an der
  Grenzschicht (5) zwischen Schmelze (2) und Gasphase
  (3) des Schmelzematerials herbeigeführt wird,
und schließlich
- die Halbleiterschicht von der Schmelze (2) getrennt
  wird.

8. Verfahren nach Anspruch 7,
d a d u r c h   g e k e n n z e i c h n e t ,   daß
infolge Konvektion und Oberflächenspannung einschließender Einflüsse die sich in der Schmelze (2) bildenden
Kristalle einer Wanderungsbewegung zur Grenzschicht (5)
unterworfen werden.

0173641

9. Verfahren nach Anspruch 7 oder 8,
d a d u r c h   g e k e n n z e i c h n e t , daß
die Kristallisation des Halbleitermaterials und die
Ausbildung der Halbleiterschicht an der Grenzfläche
(5) zwischen Schmelze (2) und Gasphase (3) durch eine
im Bereich der Grenzfläche (5) angeordnete Platte (10)
beeinflußt wird.

10. Verfahren nach Anspruch 9,
d a d u r c h   g e k e n n z e i c h n e t ,   daß
die Platte (10) dicht oberhalb der Schmelze (2) gehalten wird.

11. Verfahren nach Anspruch 9,
d a d u r c h   g e k e n n z e i c h n e t ,   daß
die Platte (10) die Oberfläche der Schmelze (2) gleitend berührt.

12. Verfahren nach Anspruch 11,
d a d u r c h   g e k e n n z e i c h n e t ,   daß
die die Oberfläche der Schmelze (2) gleitend berührende Platte (10) mit unter Druck aufgewalzten Mikrokristallen der zu züchtenden Halbleiter-Kristallschicht
(4) beschichtet ist.

13. Verfahren nach einem der Ansprüche 7 bis 12,
d a d u r c h   g e k e n n z e i c h n e t ,   daß
die Trennung der kristallinen Halbleiterschicht (4) von
der Schmelze (2) durch Kondensierung der Schmelze (2)
an einer kälteren Stelle des Kristallisationsgefäßes
(1) mittels eines Temperaturgradienten erfolgt.

14. Verfahren nach einem der Ansprüche 7 bis 12,
d a d u r c h   g e k e n n z e i c h n e t ,   daß
die Trennung der kristallinen Halbleiterschicht (4)

0173641

von der Schmelze (2) durch Anlegen eines Vakuums (6) an das Kristallisationsgefäß (1) und Abfiltern der Schmelze (2) erfolgt.

15. Verfahren nach Anspruch 14,
d a d u r c h   g e k e n n z e i c h n e t ,   daß
das Abfiltern mittels einer gesinterten Schicht (7) aus Quarzglas erfolgt.

16. Verfahren nach einem der Ansprüche 7 bis 12,
d a d u r c h   g e k e n n z e i c h n e t ,   daß
die Trennung der kristallinen Halbleiterschicht (4) von der Schmelze (2) durch seitliches Ablassen der Schmelze (2) und durch nachfolgende Sublimierung erfolgt.

17. Verwendung einer Halbleiterschicht aus einem Übergangsmetalldichalcogenid nach einem der vorangehenden Ansprüche für Solarzellen.

FIG. 1

0173641

FIG. 2 a

FIG. 2 b

$T_2$ > $T_1$

FIG. 2 c

3/6

0173641

FIG.3a

FIG.3b

0173641

FIG. 4

FIG. 5

FIG.6

0173641

FIG. 7

FIG. 8